# DEMANDE DE BREVET EUROPEEN

(11) **EP 2 432 026 A1**
(43) Date de publication de la demande: **21.03.2012**
(21) Numéro de dépôt: 10010036.1
(22) Date de dépôt: 21.09.2010
(51) Int. Cl.: H01L 31/042

(54) **Installation photovoltaïque avec protection contre les dangers d'électrocution en cas d'incendie et boîtier de sécurité pour une telle installation**

(71) Demandeur: MS ENERGIES Société privée à responsabilité limitée, 6140 Fontaine-l'Evêque (BE)
(72) Inventeur: Snauwaert, Mickael, 6470 Sivay (BE); Marziani, Anthony, 6140 Fontaine-l'Evêque (BE)
(74) Mandataire: Donné, Eddy

(57) **Abrégé**

Installation photovoltaïque avec protection contre les dangers d'électrocution en cas d'incendie, l'installation photovoltaïque (14) comprenant un nombre de panneaux photovoltaïques (2), chacun caractérisé par une puissance électrique et une tension de sortie DC, les panneaux photovoltaïques (2) étant connectés ensemble sur un câble électrique d'alimentation DC (6) branché sur un onduleur (8) pour transformer la tension DC résultante des panneaux photovoltaïques (2) en une tension AC, **caractérisée en ce que** les panneaux photovoltaïques (2) sont connectés sur le câble d'alimentation DC (6) par l'intermédiaire d'un nombre de commutateurs (16), soit d'une manière individuelle où chacun des panneaux (2) est connecté sur le câble d'alimentation DC (6) par l'intermédiaire d'un susdit commutateur (16), soit d'une manière groupée où les panneaux (2) sont interconnectés en groupes, chaque groupe étant connecté sur le câble d'alimentation DC (6) par l'intermédiaire d'un susdit commutateur (16), les groupes étant choisies de façon à ce que leur tension DC résultante ne dépasse pas une valeur maximale déterminée de façon à éviter ou à minimiser tout danger d'électrocution pour un pompier pendant les travaux d'extinction, les commutateurs (16) étant fermés en cas de fonctionnement normal de l'installation photovoltaïque (14) et pouvant être coupés en cas d'incendie.

## Description

Installation photovoltaïque avec protection contre les dangers d'électrocution en cas d'incendie.

Il est connu qu'une installation photovoltaïque comprend un nombre de panneaux photovoltaïques qui convertissent la lumière en électricité.

Les installations photovoltaïques se font actuellement surtout sur les toits des logements ou des bâtiments, soit en intégration de toiture, soit en surimposition.

Chaque panneau photovoltaïque est caractérisé par une puissance électrique et une tension de sortie en courant continu, appelé aussi courant DC, typiquement une tension relativement basse, par exemple de 30 Volts.

Les installations photovoltaïques sont généralement raccordées au réseau de distribution d'électricité.

Pour cela il est nécessaire de transformer le courant électrique continu, produit par l'ensemble des panneaux photovoltaïques, avec une tension relativement basse, aux normes du réseau, typiquement du 220 Volt à courant alternatif (courant AC) de 50 Hz.

Cette transformation se fait au niveau de l'onduleur.

Les panneaux photovoltaïques sont généralement connectés en série sur un câble électrique d'alimentation pour raccorder les panneaux photovoltaïque à l'onduleur.

Si, par exemple, six panneaux de 30 Volts DC chacun sont connectés en série, le câble d'alimentation se trouve sous tension de 180 Volts DC, qui est une tension potentiellement dangereuse pour une personne en cas de contact avec les fils électrique du câble d'alimentation.

En termes générales, le risque d'une électrocution fatal est réel pour des tensions DC au dessus de 100 Volts.

Pour autant que les panneaux photovoltaïques soient exposés à la lumière, les panneaux produisent de l'électricité et le câble d'alimentation reste sous tension, même si on coupe l'interrupteur central du tableau disjoncteur du réseau.

En cas d'incendie cela représente une menace d'électrocution réelle pour les pompiers car il est bien connu que l'eau et l'électricité ne font pas bon ménage.

Il suffit que l'eau ou l'échelle des pompiers touche un des fils du câble d'alimentation pour être électrocuté. Il n'y a d'ailleurs pas de sécurité pour couper le courant des panneaux photovoltaïques quand cela arrive puisque les panneaux restent actifs en permanence tant qu'ils sont exposés à la lumière.

Le danger est connu par les pompiers, même à ce point que certains pompiers pourraient refuser d'intervenir sur un bâtiment pourvu d'une installation photovoltaïque classique.

L'invention a pour but d'éviter les inconvénients susdits et de procurer une installation photovoltaïque qui donne une plus grande sécurité aux pompiers.

Ce but est atteint selon l'invention par une installation photovoltaïque classique comme décrit ci-avant mais dans laquelle les panneaux photovoltaïques sont connectés sur le câble d'alimentation DC par l'intermédiaire d'un nombre de commutateurs, soit d'une manière individuelle où chacun des panneaux est connecté sur le câble d'alimentation DC par l'intermédiaire d'un susdit commutateur, soit d'une manière groupée où les panneaux sont interconnectés en groupes, chaque groupe étant connecté sur le câble d'alimentation DC par l'intermédiaire d'un susdit commutateur, les groupes étant choisies de façon à ce que leur tension DC résultante ne dépasse pas une valeur maximale déterminée de façon à éviter tout danger d'électrocution pour un pompier pendant les travaux d'extinction, les commutateurs étant fermés en cas de fonctionnement normal de l'installation photovoltaïque et pouvant être coupés en cas d'incendie.

En cas d'un incendie, les pompiers peuvent couper les commutateurs pour isoler le câble d'alimentation DC des panneaux photovoltaïques.

Ainsi, le câble d'alimentation n'est plus sous tension et la tension DC maximale présente dans l'installation photovoltaïque est limitée à la tension DC d'un seul panneau photovoltaïque en cas d'un branchement individuelle ou à la tension DC résultante en cas d'un branchement par groupe de panneaux.

De préférence les panneaux photovoltaïques sont connectés individuellement au câble d'alimentation par l'intermédiaire d'un susdit commutateur.

La tension maximale est alors limitée à la tension maximale de chacun des panneaux individuels, qui est par exemple de 30 Volts DC et qui ne constitue pas de danger en cas d'une électrocution.

Les commutateurs sont préférentiellement des commutateurs bipolaire de façon à ce que les deux bornes + et - des panneaux puissent être isolées complètement du câble d'alimentation.

Les commutateurs sont de préférence des relais du type normalement ouvert qui sont reliés à un signal de commande pour fermer les relais en cas de fonctionnement normal de l'installation photovoltaïque, le signal de commande pouvant être coupé en cas d'incendie pour ouvrir les relais, par exemple par l'intermédiaire d'un sectionneur de sécurité situé tout près du tableau disjoncteur du réseau.

L'avantage d'utiliser des relais normalement ouverts est que si le signal de commande est coupé par le feu, l'installation photovoltaïque se met automatiquement en sécurité.

Selon une réalisation préférentielle, les commutateurs sont intégrés dans un boîtier étanche et éventuellement scellés dans une résine durcie pour protéger les commutateurs contre les intempéries et du vandalisme.

L'installation photovoltaïque peut avantageusement être pourvue d'un afficheur pour afficher la tension présente sur le câble d'alimentation DC.

De ce fait les pompiers disposent d'un moyen de contrôle supplémentaire pour constater que réellement il n'y a plus de courant DC sur le câble d'alimentation.

L'invention concerne également un boîtier de sécurité pour une installation photovoltaïque comme décrite ci-avant qui comprend un nombre de relais du type normalement ouvert dont l'entrée de chacun de ces relais est pourvu pour le branchement individuel d'un panneau photovoltaïque ou d'un groupe de panneaux photovoltaïques à tension DC limitée à une valeur maximale et dont les sorties sont interconnectées en série et sont pourvues pour le branchement sur un câble d'alimentation DC et que les relais sont pourvus d'une connexion pour le branchement sur un signal de commande pour fermer les relais.

Pour plus de clarté, quelques exemples de réalisation d'une installation photovoltaïque selon l'invention sont décrits ci-après à titre illustratif et non restrictif, référence étant faite aux dessins annexés dans lesquels:
La figure 1 est un schéma électrique d'une installation photovoltaïque connue appartenant à l'état de la technique;
la figure 2 représente un schéma d'une installation photovoltaïque selon l'invention dans un état normal de fonctionnement;
la figure 3 montre le schéma de la figure 2 dans un état mis en sécurité en cas d'incendie ;
la figure 4 représente une autre réalisation d'une installation photovoltaïque selon l'invention.

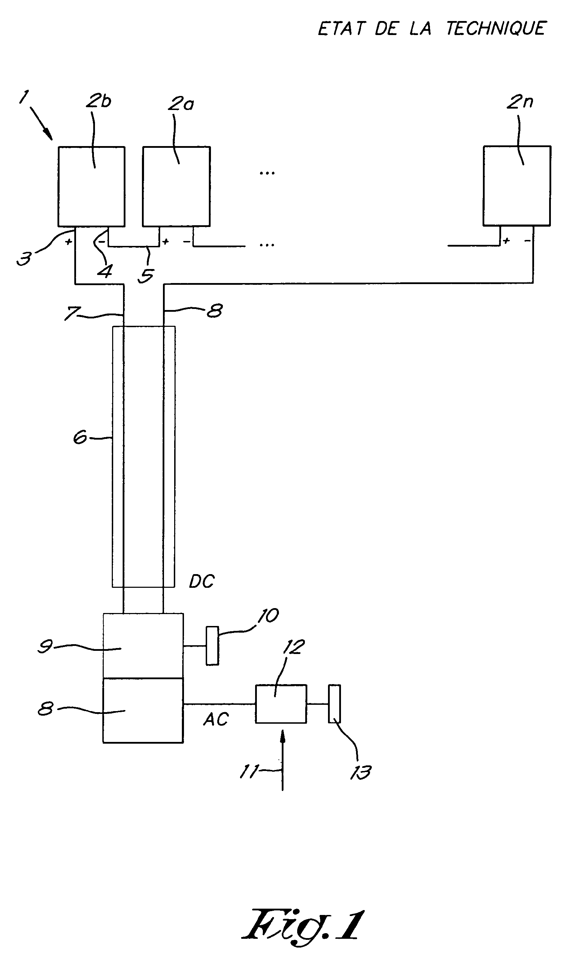

L'installation 1 selon l'état de la technique représentée dans la figure 1 est composée d'un certain nombre de panneaux photovoltaïques 2, notamment les panneaux avec référence 2a, 2b, ... 2n, qui sont par exemple montés sur le toit d'un bâtiment.

Quand les panneaux 2 sont exposés au soleil, la lumière captée par les panneaux 2 sera transformée en électricité.

Chaque panneau 2 est caractérisé par une tension VDC entre la borne positive 3 et la borne négative 4 du panneau 2, respectivement les tensions VDCa, VDCb, ... , VDCn.

Les panneaux photovoltaïques sont connectés entre eux en série, c'est-à-dire que la borne négative d'un panneau 2 est connectée via un fil électrique 5 avec la borne positive du panneau suivant.

L'ensemble des panneaux photovoltaïques 2 connectés en série est connecté sur un câble d'alimentation 6 à deux fils électriques 7.

Ce câble 6 est branché sur un onduleur 8 par l'intermédiaire d'un sectionneur 9 pouvant isoler l'onduleur 8 du câble d'alimentation 6 au moyen d'une poignée 10.

L'onduleur 8 est branché à son tour sur le réseau de distribution d'électricité 11 par l'intermédiaire d'un tableau disjoncteur 12 du réseau, qui est muni d'une poignée 13 pour pouvoir couper l'alimentation du réseau 11.

En vue de la connexion en série, le câble d'alimentation 6 se trouve sous une tension VDC qui est la somme des tensions VDCa, VDCb, ... VDCn des panneaux connectés.

Dans le cas de six panneaux 2 à 30 Volt DC par exemple, la tension sur le câble 6 sera de 180 Volt DC.

L'onduleur 8 transforme le courant continu provenant du câble d'alimentation 6 en courant alternatif AC compatible aux normes du réseau 11, par exemple en 220 Volt AV, 50 Hz.

La tension relativement élevée sur le câble d'alimentation 6 pose un problème en cas d'incendie pendant la journée puisque le câble 6 reste en permanence sous tension élevée tant que les panneaux photovoltaïques sont exposés à la lumière du jour.

Même si le sélectionneur 9 et le courant du réseau au niveau du tableau disjoncteur 12 sont coupés, une tension dangereusement élevée reste présent sur le câble 6.

Lorsque les pompiers aspergent l'installation photovoltaïque 1 pour l'extinction du feu, le risque est réel qu'un des jets d'eau touche les fils 7 et 8, avec des conséquences désastreuses pour au moins un des pompiers si la tension sur le câble d'alimentation 6 est plus élevée que 100 Volt DC, qui est pratiquement toujours le cas dans les installations connues jusqu'à présent.

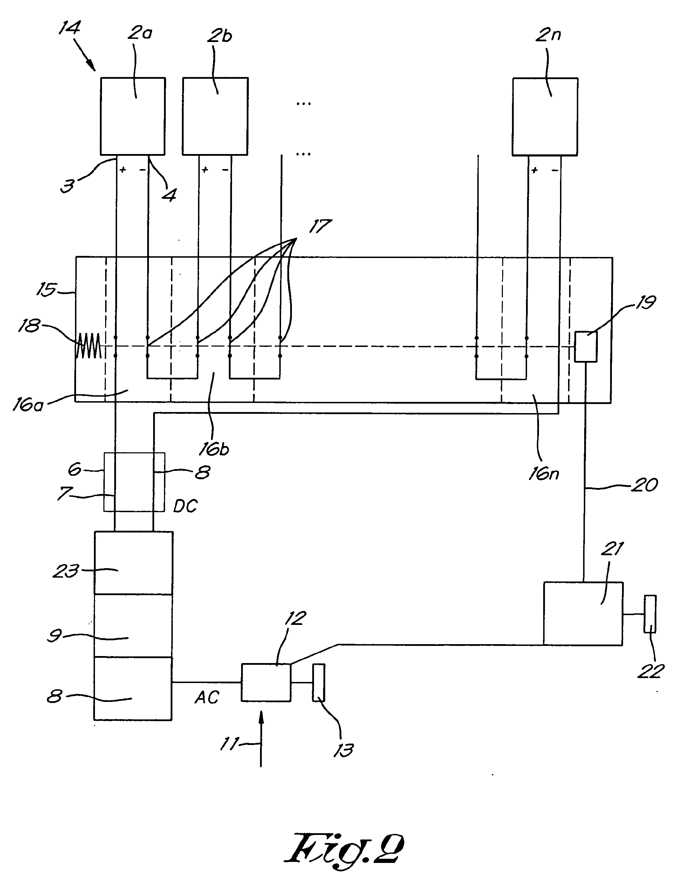

L'installation 14 selon l'invention comme représentée dans la figure 2, comprend un boîtier de sécurité 15 qui comprend autant de commutateurs bipolaires 16 qu'il y a des panneaux photovoltaïques 2.

Le boîtier est de préférence un boîtier étanche et les commutateurs 16 sont arbitrairement scellés dans une résine.

Les panneaux photovoltaïques 2 sont connectés sur les bornes d'entrée des commutateurs 16 de telle façon à ce que chacun des panneaux 2 soit connecté d'une manière individuelle sur un des commutateurs 16.

Les bornes de sortie des commutateurs 17 sont connectées en série sur le câble d'alimentation DC 6 connecté au sectionneur 9 et à l'onduleur 8 comme précédemment.

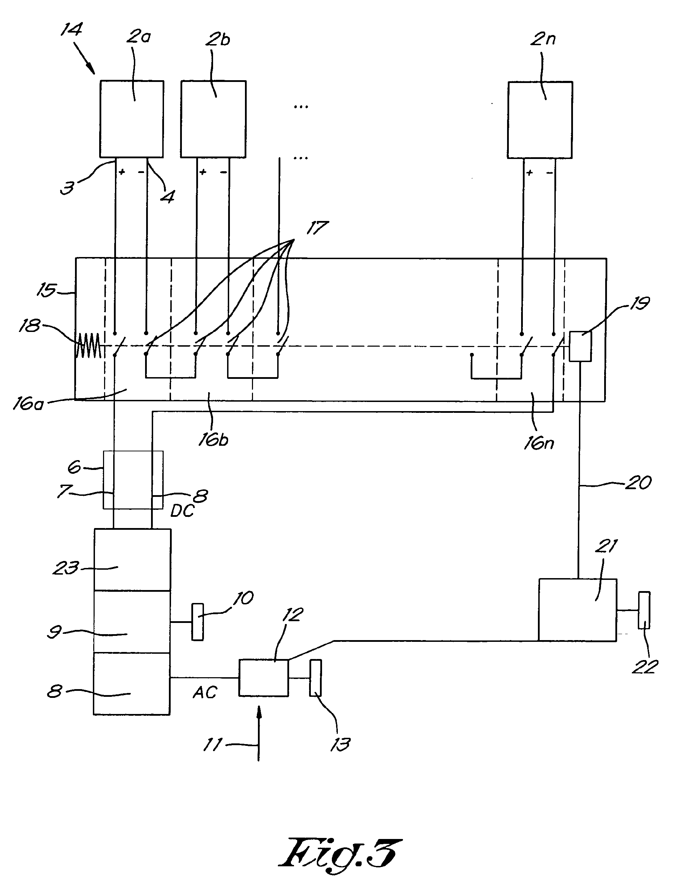

Les commutateurs 17 sont de préférence des relais du type normalement ouvert comme représenté schématiquement dans les figures 2 et 3, dont au repos les contacts 17 entre l'entrée et la sortie sont maintenus en position ouverte par un ressort de rappel 18 comme dans la situation de la figure 3.

Dans le cas représenté il s'agit plutôt d'un bloc de relais avec une seule bobine de commande 19 qui est reliée à un signal de commande 20 qui, dans ce cas, est pris du tableau disjoncteur 12 pour fermer les contacts 17 des relais-commutateurs 16.

Un sectionneur de sécurité 21 permet de couper le signal de commande 20 au moyen d'une poignée 22 par exemple afin de pouvoir ouvrir les relais 16 en cas de besoin pour isoler les panneaux 2 du câble d'alimentation 6.

Le sectionneur de sécurité 21 se trouve de préférence à un endroit près de l'onduleur 8 et donc facilement accessible pour les pompiers.

L'installation 14 est optionnellement pourvue d'un afficheur 23 pour afficher la tension sur le câble d'alimentation DC 6, cet afficheur 23 étant situé de préférence près du tableau disjoncteur 12 du réseau 11 et près du sectionneur de sécurité 21.

Le fonctionnement de l'installation est simple et comme suit.

Dans son fonctionnement normal le sectionneur de sécurité 21 est fermé pour faire passer le signal de commande 20 à la bobine 19 des relais-commutateurs 16 pour fermer les contacts 17 des relais 16 comme représenté dans la situation de la figure 2.

Dans cette situation les panneaux photovoltaïques sont branchés en série sur le câble d'alimentation 6 à travers les relais-commutateurs 16.

La tension transférée par le câble 6 à l'onduleur 8 est exactement le même que dans la situation classique de la figure 1, les panneaux 2 étant connecté en série dans les deux cas.

Pour six panneaux de 30 Volt DC il y aura donc une tension de 180 Volt DC sur le câble 6.

En cas d'incendie les pompiers peuvent couper le signal de commande 20 en actionnant la poignée 22 du sectionneur de sécurité 22.

Dans ce cas les contacts 17 sont ouverts par le ressort 18 comme représenté dans la figure 3 et le câble 6 est de ce faite complètement isolé des panneaux photovoltaïques.

Il n'y a donc plus de courant DC sur le câble 6, même si les panneaux 2 sont toujours actifs par exposition à la lumière.

Les pompiers peuvent d'ailleurs facilement contrôler l'absence de toute tension sur l'afficheur 23.

Du côté des entrées des commutateurs 16 tous les panneaux 2 sont isolés sur eux-mêmes, ce qui veut dire que la tension maximale présente dans cette partie de l'installation 14 est la tension maximale de chacun des panneaux. Dans le cas de panneaux identiques de 30 Volt DC, la tension maximale est donc de 30 Volt DC, ce qui ne pose aucun danger pour les pompiers pendant les travaux d'extinction puisque ces 30 Volt DC sont suffisamment éloignés du seuil de danger de 100 Volt DC.

Il est évident que le rôle du sectionneur de sécurité 21 peut aussi être joué par le tableau disjoncteur 12.

Il est évident aussi que le bloc de relais avec une seule bobine de commande 19 peut être remplacé par des relais individuels chacun avec sa propre bobine de commande.

Au lieu d'utiliser des commutateurs bipolaires, il est possible aussi de remplacer chacun des commutateurs par deux relais unipolaires ou par un seul relais unipolaire pour couper uniquement le côté positif ou le côté négatif des panneaux.

A part des commutateurs du type relais il n'est pas exclus d'utiliser d'autres types de commutateurs.

La commande des commutateurs ne doit pas nécessairement être une commande telle que décrite, mais peut alternativement être remplacée par une commande manuelle ; par une télécommande ; par une commande manuelle; par une commande automatique au moyen d'un détecteur d'incendie ou au moyen d'un détecteur de fumée; ou par encore d'autres types de commande.

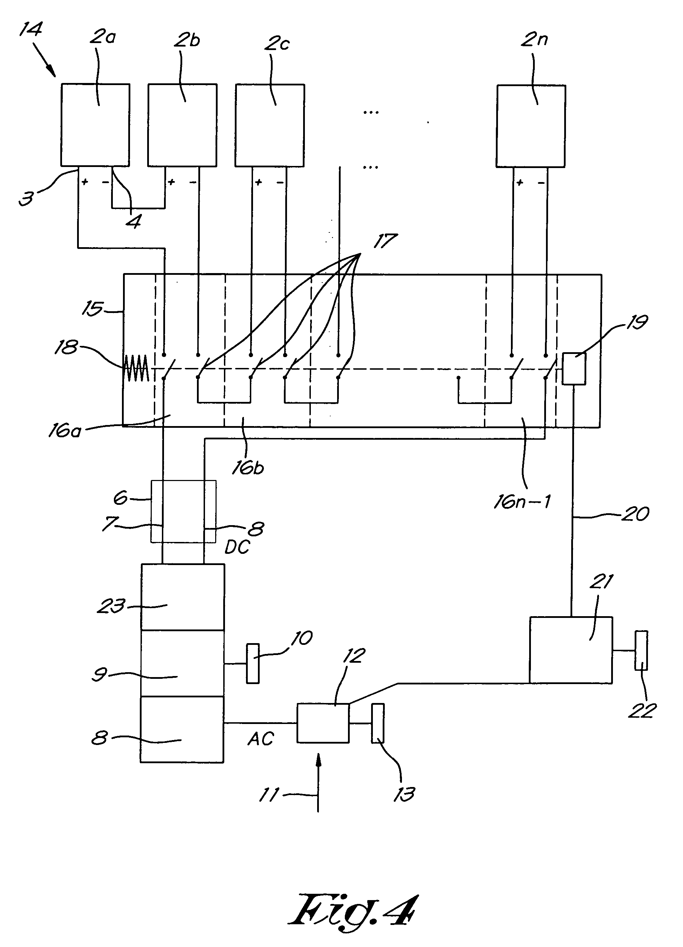

La figure 4 montre un branchement alternatif des panneaux photovoltaïques sur l'entrée des commutateurs 16 du boîtier 15.

Dans ce cas les panneaux photovoltaïques 2a et 2b sont regroupés en série et connectés comme tel sur un seul commutateur 2a, tandis que les autres panneaux 2 sont toujours connectés individuellement sur les contacteurs 16. De cette façon on peut économiser sur le nombre de commutateurs 16.

Dans ce cas la tension résultante du groupe de panneaux 2a et 2b sur les bornes du contacteur est de VDCa + VDCb, c'est-à-dire 60 Volt DC pour des panneaux de 30 Volt DC, tandis que la tension sur les bornes des autres contacteurs 16 est de 30 Volt DC.

Lorsque le sectionneur de sécurité 21 est coupé en cas d'incendie, la tension DC maximale dans l'installation sera de 60 Volt DC, ce qui est encore loin du seuil de danger de 100 Volt DC.

Pour la sécurité des pompiers il est évident qu'on doit rechercher à minimaliser la tension DC maximale dans l'installation 14 et donc de minimaliser de nombre de regroupement des panneaux en série et pour autant que possible de rechercher une connexion individuelle des panneaux 2.

De toute façon l'installateur doit rechercher une situation dans laquelle la valeur maximale de la tension DC dans l'installation photovoltaïque est de 100 Volt DC, ou mieux de 50 DC, ou mieux encore de 30 Volt DC.

Il est évident que l'invention n'est nullement limitée aux exemples décrits ci-avant mais que de nombreuses modifications peuvent être apportées à l'installation photovoltaïque selon l'invention sans sortir du cadre de l'invention.

## Revendications

1. Installation photovoltaïque avec protection contre les dangers d'électrocution en cas d'incendie, l'installation photovoltaïque (14) comprenant un nombre de panneaux photovoltaïques (2), chacun **caractérisé par** une puissance électrique et une tension de sortie DC, les panneaux photovoltaïques (2) étant connectés ensemble sur un câble électrique d'alimentation DC (6) branché sur un onduleur (8) pour transformer la tension DC résultante des panneaux photovoltaïques (2) en une tension AC, **caractérisée en ce que** les panneaux photovoltaïques (2) sont connectés sur le câble d'alimentation DC (6) par l'intermédiaire d'un nombre de commutateurs (16), soit d'une manière individuelle où chacun des panneaux (2) est connecté sur le câble d'alimentation DC (6) par l'intermédiaire d'un susdit commutateur (16), soit d'une manière groupée où les panneaux (2) sont interconnectés en groupes, chaque groupe étant connecté sur le câble d'alimentation DC (6) par l'intermédiaire d'un susdit commutateur (16), les groupes étant choisies de façon à ce que leur tension DC résultante ne dépasse pas une valeur maximale déterminée de façon à éviter ou à minimiser tout danger d'électrocution pour un pompier pendant les travaux d'extinction, les commutateurs (16) étant fermés en cas de fonctionnement normal de l'installation photovoltaïque (14) et pouvant être coupés en cas d'incendie.

2. Installation photovoltaïque selon l'une quelconque des revendications précédentes, **caractérisée en ce que** les commutateurs (16) sont branchés en série sur le câble d'alimentation DC (6).

3. Installation photovoltaïque selon la revendication 1 ou 2, **caractérisée en ce que** les commutateurs (16) sont des commutateurs bipolaires.

4. Installation photovoltaïque selon l'une quelconque des revendications précédentes, **caractérisée en ce que** les commutateurs (16) sont des relais du type normalement ouvert et que ces relais sont reliés à un signal de commande (20) pour fermer les relais en cas de fonctionnement normal de l'installation photovoltaïque (14), le signal de commande (20) pouvant être coupé pour ouvrir les relais en cas d'un incendie.

5. Installation photovoltaïque selon la revendication 4, **caractérisée en ce que** pour obtenir le signal de commande (20) les relais sont branchés sur une alimentation par l'intermédiaire d'un sectionneur de sécurité (21) qui se trouve à un endroit près de l'onduleur (8).

6. Installation photovoltaïque selon la revendication 5, **caractérisée en ce que** le signal de commande (20) est une tension prise sur le tableau disjoncteur (12) du réseau public (11).

7. Installation photovoltaïque selon la revendication 5 ou 6., **caractérisée en ce que** le sectionneur de sécurité (21) est un sectionneur commun pour tous les commutateurs (16).

8. Installation photovoltaïque selon la revendication 7, **caractérisé en ce que** le rôle du sectionneur de sécurité (21) est joué par le tableau disjoncteur (12) du réseau public (11).

9. Installation photovoltaïque selon l'une quelconque des revendications précédentes, **caractérisée en ce que** les commutateurs (16) sont intégrés dans un boîtier étanche (15).

10. Installation photovoltaïque selon l'une quelconque des revendications précédentes, **caractérisée en ce que** les commutateurs (16) sont scellés dans une résine durcie.

11. Installation photovoltaïque selon l'une quelconque des revendications précédentes, **caractérisée en ce qu'**elle est pourvue d'un afficheur (23) pour afficher la tension présente sur le câble d'alimentation DC (6).

12. Installation photovoltaïque selon la revendication 11, **caractérisée en ce que** l'afficheur de tension DC (23) est situé près du tableau disjoncteur (12) du réseau public (11).

13. Installation photovoltaïque selon l'une quelconque des revendications précédentes, **caractérisée en ce que** la valeur maximale de la tension DC de chaque panneau photovoltaïque (2) individuel ou de la tension DC résultante de chaque groupe de panneaux photovoltaïque (2) est de 100 Volt DC, ou mieux de 50 DC, ou mieux encore de 30 Volt DC.

14. Boîtier de sécurité pour une installation photovoltaïque (14) selon l'une quelconque des revendications précédentes, **caractérisée en ce qu'**elle comprend un nombre de relais (16) du type normalement ouvert dont l'entrée de chacun de ces relais (16) est pourvu pour le branchement individuel d'un panneau photovoltaïque (2) ou d'un groupe de panneaux photovoltaïques (2) à tension DC limitée à une valeur maximale et dont les sorties sont interconnectées en série et sont pourvues pour le branchement sur un câble d'alimentation DC (6) et que les relais (16) sont pourvus d'une connexion pour le branchement sur un signal de commande (20) pour fermer les relais (16).

## Revendications modifiées

### Revendications modifiées conformément à la règle 137(2) CBE.

**1.** Installation photovoltaïque avec protection contre les dangers d'électrocution en cas d'incendie, l'installation photovoltaïque (14) comprenant un nombre de panneaux photovoltaïques (2), chacun **caractérisé par** une puissance électrique et une tension de sortie DC, les panneaux photovoltaïques (2) étant connectés ensemble sur un câble électrique d'alimentation DC (6) branché sur un onduleur (8) pour transformer la tension DC résultante des panneaux photovoltaïques (2) en une tension AC, **caractérisée en ce que** les panneaux photovoltaïques (2) sont connectés sur le câble d'alimentation DC (6) par l'intermédiaire d'un nombre de commutateurs (16), soit d'une manière individuelle où chacun des panneaux (2) est connecté sur le câble d'alimentation DC (6) par l'intermédiaire d'un susdit commutateur (16), soit d'une manière groupée où les panneaux (2) sont interconnectés en groupes, chaque groupe étant connecté sur le câble d'alimentation DC (6) par l'intermédiaire d'un susdit commutateur (16), les groupes étant choisies de façon à ce que leur tension DC résultante ne dépasse pas une valeur maximale déterminée de façon à éviter ou à minimiser tout danger d'électrocution pour un pompier pendant les travaux d'extinction, les commutateurs (16) étant fermés en cas de fonctionnement normal de l'installation photovoltaïque (14) et pouvant être coupés en cas d'incendie, ces commutateurs (16) étant des relais du type normalement ouvert qui sont reliés à un signal de commande (20) pour fermer les relais en cas de fonctionnement normal de l'installation photovoltaïque (14), le signal de commande (20) pouvant être coupé pour ouvrir les relais en cas d'un incendie **en ce que** pour obtenir le signal de commande (20), les relais étant branchés à cette fin sur une alimentation par l'intermédiaire d'un sectionneur de sécurité (21) qui est commun pour tous les commutateurs (16) et qui se trouve à un endroit près de l'onduleur (8).

**2.** Installation photovoltaïque selon l'une quelconque des revendications précédentes, **caractérisée en ce que** les commutateurs (16) sont branchés en série sur le câble d'alimentation DC (6).

**3.** Installation photovoltaïque selon la revendication 1 ou 2, **caractérisée en ce que** les commutateurs (16) sont des commutateurs bipolaires.

**4.** Installation photovoltaïque selon l'une quelconque des revendications précédentes, **caractérisée en ce que** le signal de commande (20) est une tension prise sur le tableau disjoncteur (12) du réseau public (11).

**5.** Installation photovoltaïque selon l'une quelconque des revendications précédentes, **caractérisé en ce que** le rôle du sectionneur de sécurité (21) est joué par le tableau disjoncteur (12) du réseau public (11).

**6.** Installation photovoltaïque selon l'une quelconque des revendications précédentes, **caractérisée en ce que** les commutateurs (16) sont intégrés dans un boîtier étanche (15).

**7.** Installation photovoltaïque selon l'une quelconque des revendications précédentes, **caractérisée en ce que** les commutateurs (16) sont scellés dans une résine durcie.

**8.** Installation photovoltaïque selon l'une quelconque des revendications précédentes, **caractérisée en ce qu'**elle est pourvue d'un afficheur (23) pour afficher la tension présente sur le câble d'alimentation DC (6).

**9.** Installation photovoltaïque selon la revendication 11, **caractérisée en ce que** l'afficheur de tension DC (23) est situé près du tableau disjoncteur (12) du réseau public (11).

**10.** Installation photovoltaïque selon l'une quelconque des revendications précédentes, **caractérisée en ce que** la valeur maximale de la tension DC de chaque panneau photovoltaïque (2) individuel ou de la tension DC résultante de chaque groupe de panneaux photovoltaïque (2) est de 100 Volt DC, ou mieux de 50 DC, ou mieux encore de 30 Volt DC.

**11.** Boîtier de sécurité pour une installation photovoltaïque (14) selon l'une quelconque des revendications précédentes, **caractérisée en ce qu'**elle comprend un nombre de relais (16) du type normalement ouvert dont l'entrée de chacun de ces relais (16) est pourvu pour le branchement individuel d'un panneau photovoltaïque (2) ou d'un groupe de panneaux photovoltaïques (2) à tension DC limitée à une valeur maximale et dont les sorties sont interconnectées en série et sont pourvues pour le branchement sur un câble d'alimentation DC (6) et que les relais (16) sont pourvus d'une connexion pour le branchement commun sur un signal de
commande (20) pour fermer les relais (16).
